(19) Europäisches Patentamt

European Patent Office

Office européen des brevets

(11) **EP 1 439 435 A1**

## (12) EUROPEAN PATENT APPLICATION
published in accordance with Art. 158(3) EPC

(43) Date of publication:
**21.07.2004 Bulletin 2004/30**

(21) Application number: **03791364.7**

(22) Date of filing: **28.08.2003**

(51) Int Cl.⁷: **G04C 3/12**, H02N 2/00

(86) International application number:
**PCT/JP2003/010914**

(87) International publication number:
**WO 2004/021091 (11.03.2004 Gazette 2004/11)**

(84) Designated Contracting States:
**AT BE BG CH CY CZ DE DK EE ES FI FR GB GR HU IE IT LI LU MC NL PT RO SE SI SK TR**

(30) Priority: **30.08.2002 JP 2002253578**
**31.03.2003 JP 2003094252**

(71) Applicant: **SEIKO EPSON CORPORATION**
**Tokyo 160-0811 (JP)**

(72) Inventors:
• **SAWADA, Akihiro**
**Suwa-shi, Nagano 392-8502 (JP)**

• **MARUYAMA, Akihiko**
**Suwa-shi, Nagano 392-8502 (JP)**
• **KITAHARA, Joji**
**Suwa-shi, Nagano 392-8502 (JP)**

(74) Representative: **Sturt, Clifford Mark et al**
**Miller Sturt Kenyon**
**9 John Street**
**London WC1N 2ES (GB)**

## (54) ANALOG ELECTRONIC TIMEPIECE

(57)     In order to provide an electronic timepiece having high transfer efficiency and a compact and thin structure, there are provided a plate-like piezoelectric actuator 341, a driven body 343 driven with a vibration of the piezoelectric actuator 341, and a time-indicating mechanism 5 operating with a drive of the driven body 343 via a transfer mechanism 4.

FIG. 2

**Description**

Technical Field

The present invention relates to an analog electronic timepiece having a piezoelectric actuator used therein.

Background Art

Heretofore proposed timepieces include a vibrator inducing a vibration by utilizing a piezoelectric effect of piezoelectric elements; a driven body driven to rotate with the vibration of the vibrator; and indicating means operating with a rotation of the driven body.

In a timepiece, for example, disclosed in Japanese Unexamined Patent Application Publication No. 62-223689 as one of such timepieces, a vibration of the vibrator is converted into a rotational movement by a ratchet. This structure causes a problem of poor conversion efficiency. Because of this problem, a product like a timepiece having a power source used therein, which is built in a limited space thereof, ends up having a very short lifetime of a battery. In order to solve this problem, the timepiece must have a bulky battery with a large capacity mounted therein, which causes problems of an increased size and thus a limitation to the design of the time piece.

Also, a timepiece disclosed in a patent document of Japanese Unexamined Patent Application Publication No. 60-113675, Japanese Unexamined Patent Application Publication No. 63-113990, or Japanese Examined Patent Application Publication No. 7-39175 has a wedge structure or a ringshaped motor structure employed therein. These timepieces have a structure in which an elliptical motion having the major axis extending in the thickness direction of the body of the timepiece is converted into a rotational motion in a plane direction perpendicular to the thickness direction of the body of the timepiece. Since the elliptical motion has a very small displacement in the plane direction, energy-conversion efficiency for converting it to the rotational movement is very poor.

Accordingly, the above-mentioned problem causes these products to have a very short lifetime of a battery in the same fashion as the timepiece disclosed in Japanese Unexamined Patent Application Publication No. 62-223689. In order to solve this problem, although a mechanism for magnifying a displacement in the plane direction has been proposed, this mechanism extends in the thickness direction. Since the vibrator and the driven body overlap basically with each other in the thickness direction in this type of structure, the above mechanism makes the timepiece further thicker, thereby causing a serious problem in that the body of the timepiece is prevented from having a thin structure.

Accordingly, it is an object of the present invention to provide an analog electronic timepiece which solves the above-mentioned problems of the related art and which achieves high conversion efficiency and a compact and thin structure.

Disclosure of the Invention

A first form of the present invention is characterized in that there are provided a plate-like vibrator; a driven body driven with a vibration of the vibrator; and a time-indicating mechanism operating directly with a drive of the driven body or via a transfer mechanism.

Also, a second form of the present invention is characterized in that, in the first form, the plate-like vibrator is a piezoelectric actuator which includes a diaphragm formed by stacking at least one plate-like piezoelectric element and a plate-like reinforcing member; at least one fixing portion for fixing the diaphragm to a supporting body; and an abutment portion disposed at a longitudinal end of the diaphragm, and in which, by feeding a drive signal to the piezoelectric element, the piezoelectric element expands and contracts so as to generate vibrations causing the diaphragm to expand and contract in the longitudinal direction thereof as well as in a direction at an angle with the longitudinal direction so that the driven body is driven with a displacement of the abutment caused by these vibrations, and the abutment portion and the driven body are pressed by pressing means.

Also, a third form of the present invention is characterized in that, in the first or second form, the vibrator is disposed so as not to overlap two-dimensionally with the driven body or the transfer mechanism.

Also, a fourth form of the present invention is characterized in that, in the first or second form, the vibrator is disposed so as to overlap two-dimensionally with a mechanism including the transfer mechanism and the time-indicating mechanism.

Also, a fifth form of the present invention is characterized in that, among component members constituting the analog electronic timepiece, the vibrator is disposed so as to overlap two-dimensionally with a part of the component members which do not affect an increase in thickness after its arrangement.

Also, a sixth form of the present invention is characterized in that, in the first or second form, the driven body includes pressing means for pressing the vibrator.

Also, a seventh form of the present invention is characterized in that, in the first or second form, the vibrator includes pressing means for pressing the driven body.

Also, an eighth form of the present invention is characterized in that, in the seventh form, a pressing force of the pressing means is exerted substantially in a circumferential direction of a driven wheel which is the driven body and is the first to be driven among the transfer mechanism.

Also, a ninth form of the present invention is characterized in that, in the seventh form, a pressing force of the pressing means is exerted substantially in the center-oriented direction of a driven wheel which is the driven body and is the first to be driven among the transfer mechanism.

Brief Description of the Drawings

Fig. 1 is a block diagram illustrating an embodiment of the present invention.

Fig. 2 is a front plan view of an analog electronic timepiece.

Fig. 3 is a sectional view of the analog electronic timepiece.

Fig. 4 is another sectional view of the analog electronic timepiece.

Fig. 5 is a sectional view of a piezoelectric actuator.

Fig. 6 is a side view of the piezoelectric actuator.

Fig. 7 is a plan view of the piezoelectric actuator.

Fig. 8 is a magnified view of an abutment portion of the piezoelectric actuator.

Fig. 9 is a sectional view of an analog electronic timepiece according to a second embodiment.

Fig. 10 is a plan view of a pressing structure of the piezoelectric actuator according to a third embodiment.

Fig. 11 is a plan view of a pressing structure of the piezoelectric actuator according to a fourth embodiment.

Fig. 12 is a plan view of an analog electronic timepiece according to a sixth embodiment.

Fig. 13 is a sectional view of a time-indicating mechanism including a piezoelectric actuator according to the sixth embodiment.

Fig. 14 is a graph illustrating a frequency vs. impedance characteristic of the piezoelectric actuator having a concrete structure.

Fig. 15 is an illustration of an example electrode arrangement of a piezoelectric actuator.

Fig. 16 is an illustration of an electrode arrangement of another piezoelectric actuator.

Fig. 17 is an illustration of an electrode arrangement of a piezoelectric actuator for a drive in both normal and reverse directions.

Fig. 18 is an illustration of an electrode arrangement of another piezoelectric actuator for a drive in both normal and reverse directions.

Best Mode for Carrying Out the Invention

Preferred embodiments of the present invention will be described in accordance with the drawings.

[1] First Embodiment

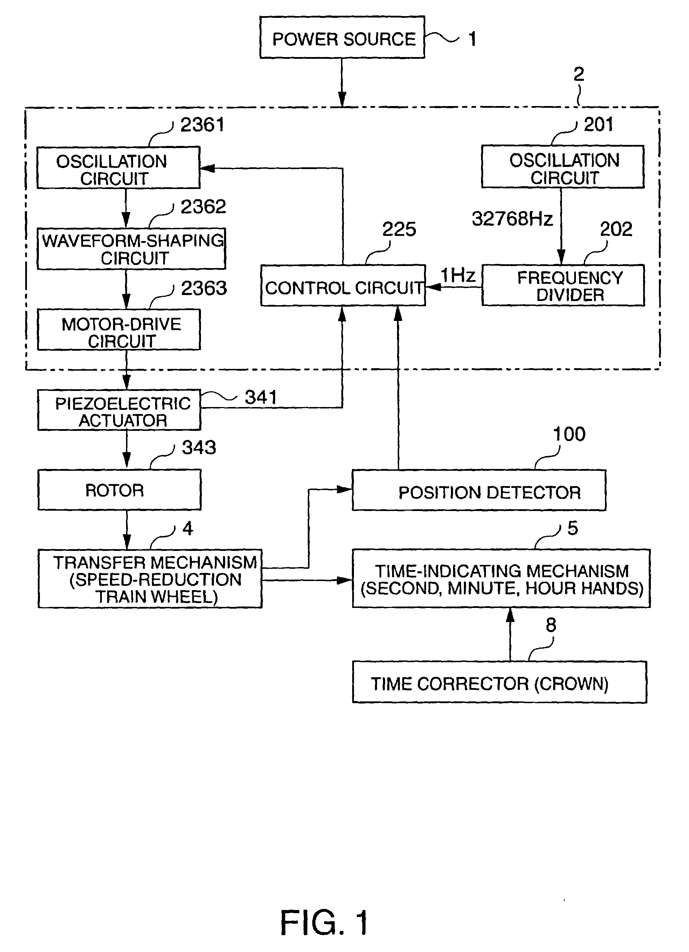

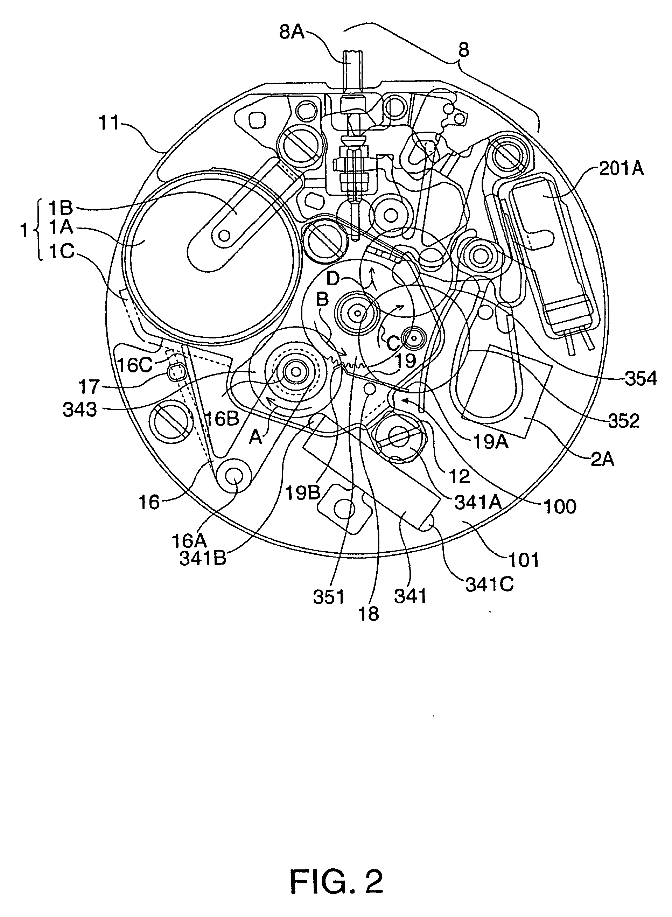

Fig. 1 is a block diagram illustrating an analog electronic timepiece according to a first embodiment, and Fig. 2 is a front plan view of the same analog electronic timepiece.

In the timepiece shown in Fig. 1, a control object is a time-indicating mechanism 5, and the time-indicating mechanism 5 operates with a piezoelectric actuator 341. As shown in Fig. 1, upon receipt of electric energy from a power source 1, an oscillation circuit 201 of an electronic circuit 2 transmits a signal having a frequency of 32,768 Hz and serving as a reference signal. This reference signal is converted so as to have a frequency of 1 Hz with a frequency divider 202. The signal from the frequency divider 202 is transmitted to a control circuit 225. The control circuit 225 controls supply-timing of a drive pulse of the piezoelectric actuator 341 serving as a drive source of the time-indicating mechanism 5. Also, the control circuit 225 inputs a drive-pulse command signal to an oscillation circuit 2361 which feeds a drive pulse to the piezoelectric actuator 341.

When the drive-pulse command signal whose supply-timing is controlled with the control circuit 225 is inputted into the oscillation circuit 2361, the drive-pulse command signal is inputted into a motor-drive circuit 2363 via a wave-shaping circuit 2362. Thus, the motor-drive circuit 2363 supplies the drive pulse to the piezoelectric actuator 341. In accordance with the drive pulse, the piezoelectric actuator 341 converts electric energy into mechanical energy by making use of its piezoelectric effect so as to prod the periphery of a driven body (rotor) 343. This prodding causes the rotor 343 to rotate such that a transfer mechanism (speed-reduction train wheel) 4 is driven to rotate so as to drive the time-indicating mechanism 5. Indication of the time-indicating mechanism 5 is adjusted by a time corrector 8.

Fig. 2 is the plan view of the analog electronic time piece.

As shown in Fig. 2, the various mechanisms illustrated in the block diagram shown in Fig. 1 are arranged on a base plate 11 in a well-organized manner.

More particularly, a battery 1A, a negative terminal 1B, and a positive terminal 1C, the three constituting the power source 1, the time corrector 8 including a crown 8A, a quartz oscillator 201A constituting the oscillation circuit 201, an IC 2A having the electronic circuit 2 formed therein, the time-indicating mechanism 5 including the piezoelectric actuator 341 serving as a drive source, all constituting the analog electronic timepiece, are arranged on the base plate 1 in a well-organized manner. Reference numeral 101 shown in Fig. 2 denotes a circuit retainer which also comes into contact with the battery 1A.

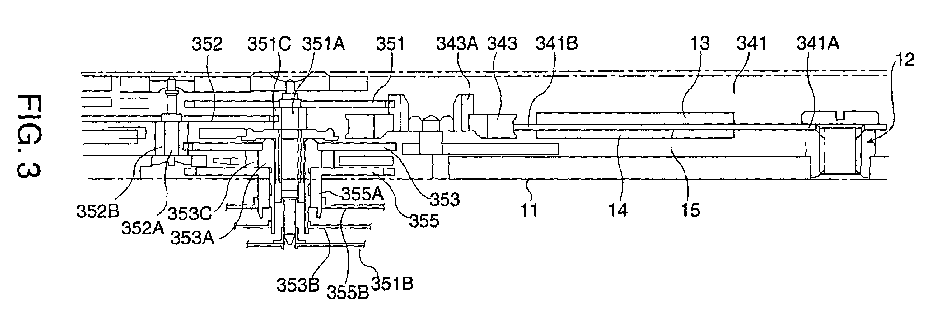

Fig. 3 is a sectional view of the time-indicating mechanism 5 including the piezoelectric actuator 341.

The piezoelectric actuator 341 is a plate-like vibrator having a substantially rectangular shape (Fig. 2). The piezoelectric actuator 341 is a vibrator which performs a vibration in its longitudinal direction (hereinafter, referred to as a longitudinal vibration) and a vibration in its lateral direction (hereinafter, referred to as a secondary flexural vibration) when it has a voltage applied thereon as will be described later.

The piezoelectric actuator (vibrator) 341 has fixing portions 341A integrally formed with the middle portion thereof. One of the fixing portions 341A is fixed to the base plate 11 with a fixing pin 12. The piezoelectric actuator 341 is arranged so as to be substantially parallel to the base plate 11.

The piezoelectric actuator 341 has an abutment portion 341B disposed at the top thereof. Thus, since the piezoelectric actuator 341 performs a longitudinal vibration and a secondary flexural vibration, the top portion of the abutment portion 341B comes into contact with the periphery of the rotatably-supported rotor 343 while depicting an elliptical path.

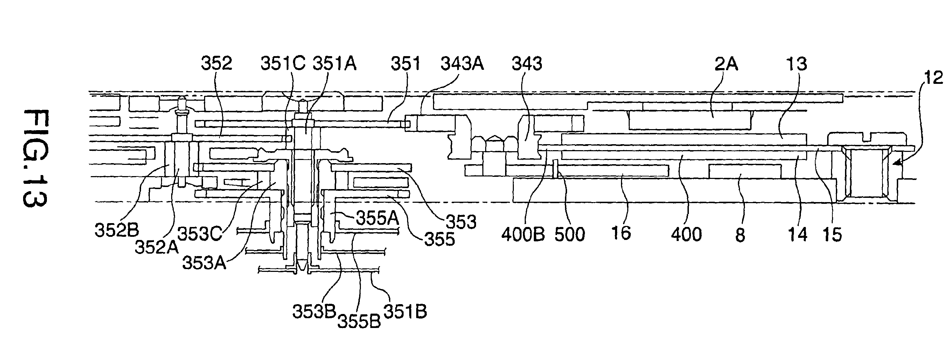

When the top portion of the abutment portion 341B comes into contact with the periphery of the rotor 343, the rotor 343 rotates in the arrow A direction indicated in Fig. 13 with a frictional force. Then, a driven wheel 343A integrally formed with the rotor 343 rotates in the same direction. Furthermore, the driven wheel 343A has a fourth wheel 351 engaging therewith, which rotates in the arrow B direction indicated in Fig. 2. A second hand 351B fixed to a rotating shaft 351A is driven with a rotation of the fourth wheel 351.

Also, the rotating shaft 351A of the fourth wheel 351 has a driven wheel 351C fixed thereto. The driven wheel 351C has a third wheel 352 engaging therewith, and the third wheel 352 rotates in the arrow C direction indicated in Fig. 2. A rotating shaft 352A of the third wheel 352 has a driven wheel 352B fixed thereto. The driven wheel 352B has a second wheel 353 engaging therewith. A minute hand 353B fixed to a rotating shaft 353A of the second wheel 353 is driven with a rotation of the second wheel 353.

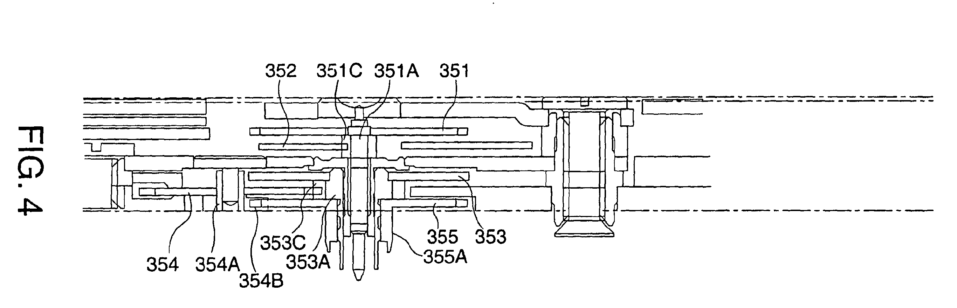

The rotating shaft 353A of the second wheel 353 has a driven wheel 353C fixed thereto as shown in Fig. 4. The driven wheel 353C has a minute wheel 354 engaging therewith, and thus the minute wheel 354 rotates in the arrow D direction indicated in Fig. 1.

A rotating shaft 354A of the minute wheel 354 has a driven wheel 354B fixed thereto, which has a scoop wheel 355 engaging therewith. An hour hand 355B fixed to a rotating shaft 355A of the scoop wheel 355 is driven with a rotation of the scoop wheel 355.

With the above-mentioned arrangement, the driven body 343, the fourth wheel 351, the third wheel 352, the second wheel 353, the minute wheel 354, the scoop wheel 355, and so forth constitute the transfer mechanism (speed-reduction train wheel) 4 and the time-indicating mechanism 5.

In the present embodiment, the piezoelectric actuator 341 serves as a drive source of the timepiece. As a result, the analog electronic timepiece according to the present embodiment is more resistant to an external magnetic field than a timepiece in which an electromagnetic motor serves as a drive source. Also, the number of components of the drive source is smaller.

Also, the analog electronic timepiece according to the present embodiment has a large generated-torque and a reduced number of the transfer wheel train. Thus, costs including a component cost and a timepiece-assembling cost can be reduced.

In addition, the large generated-torque allows wide and thick indicating hands including a second hand, a minute hand, and an hour hand to be fixed. Thus, this structure leads to a timepiece offering excellent visibility and providing a massive feel. Also, its frictional drive does not cause the hands to fluctuate, thereby leading to a timepiece having excellent positioning accuracy.

Furthermore, since the piezoelectric actuator 341 has a structure in which a vibrational motion in the plane direction is converted into a rotational motion of the rotor 343, the piezoelectric actuator 341 has no components overlapping therewith, thereby achieving a thin structure. Also, since the piezoelectric actuator 341 vibrates in the rotating direction of a part of the wheel train which is the rotor 343, thereby achieving high transfer efficiency. In addition, an affect of vibration leakage on the base plate 11 or the like can be prevented.

With the foregoing structure, the piezoelectric actuator 341 is arranged so as not to overlap two-dimensionally with the fourth wheel 351, the third wheel 352, the second wheel 353, the minute wheel 354, the scoop wheel 355, and the like. Accordingly, the timepiece has a thin structure.

As shown in Fig. 2, the piezoelectric actuator 341 is fixed to the base plate 11 with the fixing pin 12 by screwing, swaging, welding, or the like while the rotor 343 is always pressed toward the piezoelectric actuator 341 with a pressing member 16 (pressing means). Here, the pressing member 16 is arranged so as not to overlap two-dimensionally with the piezoelectric actuator 341.

The pressing member 16 is a U-shaped elastic plate fixed to the base plate 11 with a pin 16A. The rotor 343 is retained at one end 16B of the pressing member 16. Also, another end 16c of the pressing member 16 is retained by a pin 17 fixed to the base plate 11. With the arrangement, the pressing member 16 presses the rotor 343 toward the piezoelectric actuator 341 with a restoring force of the U-shaped plate.

According to the structure in which the rotor 343 is pressed toward the piezoelectric actuator 341 by the pressing member 16, the piezoelectric actuator 341 is fixed with the fixing pin 12 by screwing, swaging, welding, or the like. Thus, a portable device such as a timepiece experiencing a shock is prevented from deterioration in its drive characteristic and a damage of its vibrator. Also, the length of a wiring path for applying a drive signal does not vary, thereby ensuring a stable conducting condition. In addition, the stiffness of the piezoelectric actuator 341 increases, thereby improving efficiency of transferring energy to the transfer mechanism.

As shown in Fig. 3, the piezoelectric actuator 341 is constructed such that two plate-like piezoelectric elements 13 and 14 have a plate-like backing board 15 sandwiched therebetween, composed of a metal such as a stainless steel. The backing board 15 has the foregoing fixing portions 341A and abutment portion 341B integrally formed therewith. According to the stacking structure in which the backing board 15 is sandwiched by the piezoelectric elements 13 and 14, the piezoelectric elements 13 and 14 is prevented from damage due to an excessive amplitude or an external force of the piezoelectric actuator 341. Here, the piezoelectric elements 13 and 14 are arranged so as not to overlap two-dimensionally with the fixing portions 341A.

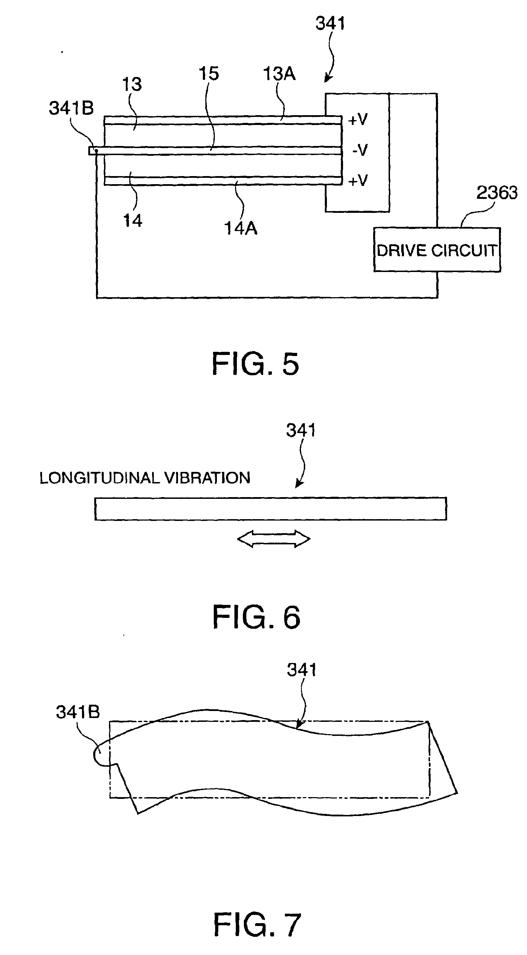

As shown in Fig. 5, the piezoelectric elements 13 and 14 have respective electrode 13A and 14A disposed on the surfaces thereof. Thus, a drive voltage from the drive circuit 2363 is applied on the piezoelectric elements 13 and 14 via the electrodes 13A and 14A. When polarization directions of the piezoelectric element 13 and the piezoelectric element 14 are opposite to each other, by supplying alternating drive signals from the drive circuit 2363 so as to provide the upper surface, the center surface, and the lower surface shown in Fig. 5 with electric potentials of +V, -V, and +V (or -V, +V, and -V), respectively, the piezoelectric elements 13 and 14 are displaced in an expanding and contracting manner. Here, the drive signals for +V and -V are alternating signals having phases inverted to each other. With this arrangement, with respect to that of the backing board 15, the amplitudes of vibrations generated in the upper piezoelectric element 13 and the lower piezoelectric element 14 can be made greater than those when applying 0 V to the backing board 15 (when the backing board 15 is connected to a ground of the drive circuit 2363). Meanwhile, in Fig. 5, supply electrodes lying in contact with the piezoelectric elements 13 and 14 are omitted for convenience of explanation, and only the electrodes 13A and 14A lying on the surface are illustrated.

The piezoelectric elements 13 and 14 are composed of material such as lead zirconate titanate, crystal, lithium niobate, barium titanate, lead titanate, lead metaniobate, poly(vinylidene fluoride), lead zinc niobate, or lead scandium niobate.

Next, an operation of the piezoelectric actuator 341 will be described.

When alternating drive signals are applied on the piezoelectric elements 13 and 14 from the drive circuit 2363 via the electrodes 13A and 14A, a longitudinal vibration which expands and contracts in the longitudinal direction is generated in each of the piezoelectric elements 13 and 14, as shown by the arrow indicated in Fig. 6. As mentioned above, when the piezoelectric actuator 341 is electrically excited with a longitudinal vibration by applying the drive signals on the piezoelectric elements 13 and 14, the piezoelectric actuator 341 has a toque generated about the center of gravity thereof due to an imbalance in weight of the piezoelectric actuator 341. As shown in Fig. 7, this torque induces a secondary flexural vibration which causes the piezoelectric actuator 341 to fluctuate in the lateral direction.

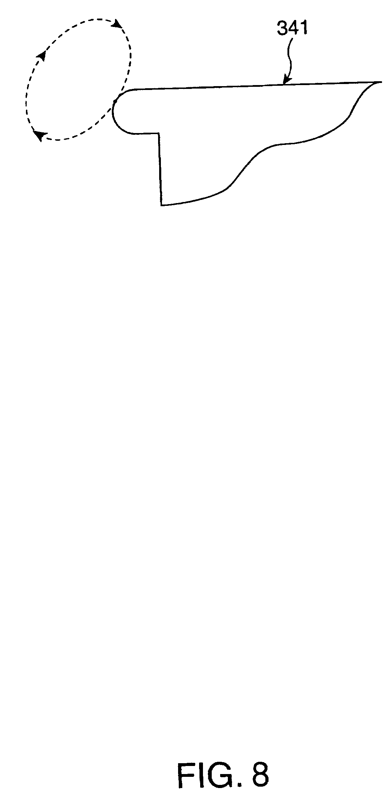

As described above, the longitudinal vibration and the secondary flexural vibration are generated in the piezoelectric actuator 341, and the longitudinal vibration and the secondary flexural vibration are combined. With this arrangement, the top portion of the abutment portion 341B of the piezoelectric actuator 341 moves along an elliptical path as shown in Fig. 8. Since the top portion of the abutment portion 341B depicts an elliptical path in the clockwise direction, when the abutment portion 341B lies in heavy contact with the rotor 343, the abutment portion 341B presses the rotor 343 with a large force. On the other hand, when the abutment portion 341B lies in light contact with the rotor 343, the abutment portion 341B presses the rotor 343 with a small force. Accordingly, while a large pressing force of the abutment portion 341B is exerted on the rotor 34, that is, when the abutment portion 341B lies in heavy contact with the rotor 343, the rotor 343 is driven to rotate in a displacement direction of the abutment portion 341B. In the present embodiment, when the rotor 343 rotates in the arrow A direction indicated in Fig. 2 in accordance with a displacement of the abutment portion 341B of the piezoelectric actuator 341, the time-indicating mechanism 5 operates.

Meanwhile, when the piezoelectric actuator 341 is used in a timepiece, it is necessary to detect a rotational position of the rotor 343 to which the rotor is rotated by prodding the piezoelectric actuator 341. To achieve this, as shown in Fig. 2, the fourth wheel 351 and a conductive pin 18 have a position detector 100 interposed therebetween.

The position detector 100 has a jumper spring 19. One end 19A of the jumper spring 19 is fixed to the base plate 11, for example, by screwing. The jumper spring 19 has a knocking portion 19B formed at the other end thereof, which is bent in a substantially V-shape. The knocking portion 19B engages with sixty teeth formed around the periphery of the fourth wheel 351.

An operation of the position detector 100 will be now described.

With reference to Fig. 1, when a signal with a frequency of 1 Hz from the oscillation circuit 201 and the frequency divider 202 causes the oscillation circuit 2361 to be driven via the control circuit 225, the piezoelectric actuator 341 starts to prod the rotor 343 so that the rotor 343 is driven to rotate. With this arrangement, the fourth wheel 351 is driven to rotate in the arrow B direction as shown in Fig. 2. When the fourth wheel 351 rotates, the knocking portion 19B of the jumper spring 19 moves back and forth in accordance with tooth shaped undulations of the fourth wheel 351. When the jumper spring 19 is deformed, the jumper spring 19 having a high electric potential VDD comes into contact with the conductive pin 18. After then, the fourth wheel 351 rotates further, and the position detector 100 operates upon detachment of the jumper spring 19 from the conductive pin 18, so that the position detector 100 inputs an oscillation-halt command to the control circuit 225, which is directed to the oscillation circuit 2361.

In other words, in the present embodiment, after the start of a prodding operation of the piezoelectric actuator 341, when the jumper spring 19 comes to a position at which it climbs on one of the sixty teeth formed around the periphery of the fourth wheel 351, the position detector 100 detects this position. Then, the oscillation-halt command is inputted into the oscillation circuit 2361 so as to halt the prodding operation of the piezoelectric actuator 341. This operation is performed for one second.

Then, when the subsequent signal with a frequency of 1 Hz from the frequency divider 202 causes the oscillation circuit 2361 to be driven via the control circuit 225, the piezoelectric actuator 341 starts its prodding operation again, so that and the rotor 343 is driven to rotate. By repeating this operation, the time-indicating mechanism 5 is driven via the transfer mechanism 4.

When the foregoing structure is applied to a wrist watch, since the piezoelectric actuator 341 extends substantially parallel to a human arm, and a vibration of the piezoelectric actuator 341 is not exerted in any directions perpendicular to the arm, the vibration is not amplified.

Also, from the viewpoint of a design feature, some wrist watches have a curved shape in which the positions of twelve o'clock and six o'clock on the dial lie low so as to extend along the shape of the arm. In this case, by disposing the piezoelectric actuator 341, for example, between the positions of four o'clock and eight o'clock, the foregoing structure is easily applied to a wrist watch having the above-mentioned shape.

[2] Second Embodiment

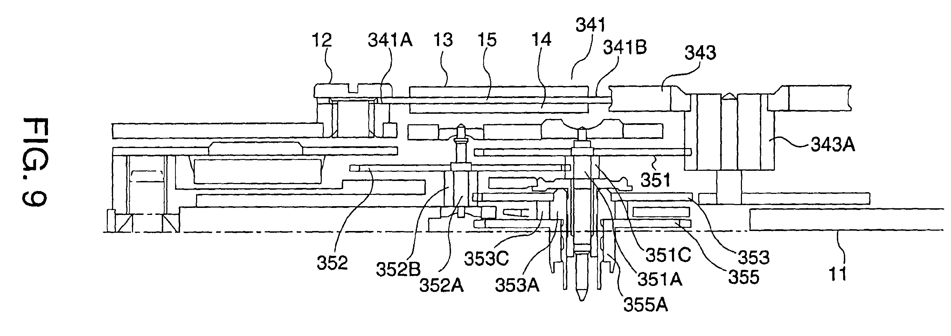

Fig. 9 is a sectional view of an analog electronic timepiece according to a second embodiment.

In the second embodiment, the piezoelectric actuator 341 is disposed so as to overlap two-dimensionally with a mechanism including the transfer mechanism 4 and the time-indicating mechanism 5. More particularly, the piezoelectric actuator 341 and the rotor 343 are disposed so as to face each other, having the mechanism including the transfer mechanism 4 and the time-indicating mechanism 5 interposed therebetween, and are disposed at the backsides of the transfer mechanism 4 and the time-indicating mechanism 5 so as to overlap two-dimensionally with these mechanisms. The remaining structure is substantially the same as those that in the foregoing embodiment, and the same parts as in Fig. 3 are represented by the same reference numerals.

In the second embodiment, the piezoelectric actuator 341 is composed of a thin plate. Thus, even when the piezoelectric actuator 341 is disposed so as to overlap two-dimensionally with a mechanism including the fourth wheel 351, the third wheel 352, the second wheel 353, the minute wheel 354, the scoop wheel 355, and the like, the timepiece does not become large so much in the height direction thereof. Accordingly, the timepiece becomes smaller by the size of a drive body (actuator) than those with the related art.

[3] Third Embodiment

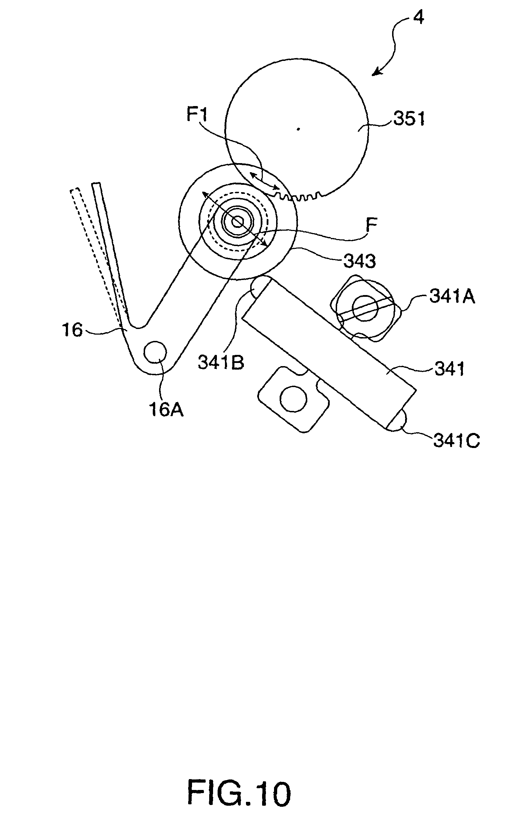

Fig. 10 is a plan view of a pressing structure of the piezoelectric actuator according to a third embodiment. In Fig. 10, the same parts as those in Fig. 2 are represented by the same reference numerals.

In the third embodiment, the arrangement relationship among the piezoelectric actuator 341, the rotor 343, and the fourth wheel 351 is set such that a pressing force F of the pressing member 16 is exerted in a direction substantially in agreement with a circumferential direction F1 of the fourth wheel (driven wheel) 351 which is the first to be driven by the rotor 343 among the transfer mechanism 4. With this structure, the pressing member 16 presses and urges the rotor 343 toward the piezoelectric actuator 341. That is, the rotor 343 moves parallel to the plane of the figure. Meanwhile, when the rotor 343 moves parallel to the plane, the center distance between the rotor 343 and the fourth wheel 351 varies, thereby causing a risk of making transfer efficiency unstable.

However, in the present embodiment, since the pressing force F of the pressing member 16 is exerted substantially in the circumferential direction F1 of the fourth wheel 351, the center distance between the rotor 343 and the fourth wheel 351 is maintained constant, thereby making the transfer efficiency stable.

[4] Fourth Embodiment

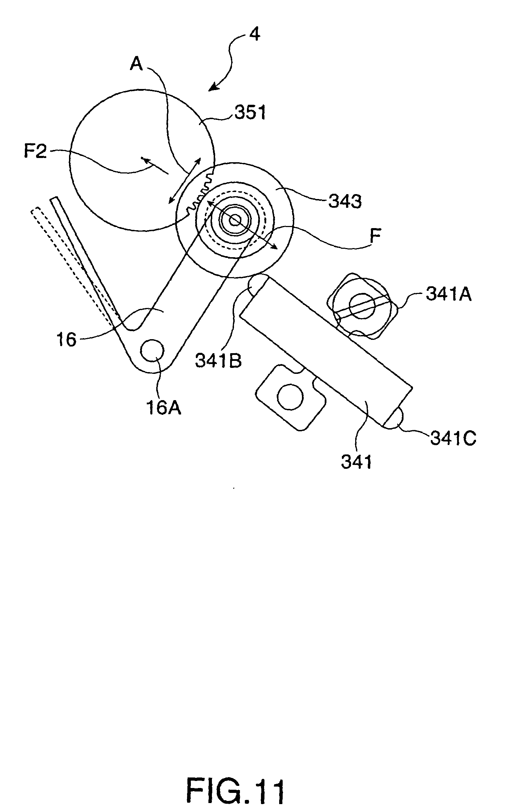

Fig. 11 is a plan view of a pressing structure of the piezoelectric actuator according to a fourth embodiment. In Fig. 11, the same parts as those in Fig. 2 are represented by the same reference numerals.

In the fourth embodiment, the arrangement relationship among the piezoelectric actuator 341, the rotor 343, and the fourth wheel 351 is set such that the pressing force F of the pressing member 16 is exerted substantially in a center-oriented direction F2 of the fourth wheel (driven wheel) 351 which is the first to be driven by the rotor 343 among the transfer mechanism 4.

With this structure, since the direction of a receiving force of the rotor 343 caused by a load torque of the wheel train of a timepiece (the direction of the pressing force F) is substantially perpendicular to the rotational direction of the rotor 343 (the arrow A direction), the pressing force F of the pressing member 16 does not fluctuate. Accordingly, a stable drive with the prodding operation of the piezoelectric actuator 341 is achieved. Even when a shock is exerted on the timepiece, it affects little on the transfer of rotation from the rotor 343 to the fourth wheel 351, thereby preventing time indication of the time-indicating mechanism 5 from being shifted.

[5] Fifth Embodiment

According to a fifth embodiment, without the pressing member 16, a pressing structure is achieved in which the piezoelectric actuator 341 is pressed and urged toward the rotor 343 by means similar to the pressing member 16. In this case, the rotor 343 does not move parallel to the plane of the figure; instead, the piezoelectric actuator 341 moves parallel to the plane. In other words, since the rotor 343 does not move parallel to the plane, the center distance between the rotor 343 and the fourth wheel 351 is maintained constant, thereby making the transfer efficiency stable.

[6] Sixth Embodiment

According to a sixth embodiment, among component members constituting an analog electronic timepiece, the vibrator is disposed so as to overlap two-dimensionally with a part of the component members which do not affect an increase in thickness after its arrangement.

To be more specific, the part of the component member which do not affect an increase in thickness after the arrangement include a circuit board, an IC circuit, the train wheel, the base plate, a variety of receiving members, a time correcting member, and the circuit retainer. Also, a gear, a pressure spring, a pressing plate, the base plate, and the like disposed above and below a rotor wheel can be disposed so as to overlap two-dimensionally with the vibrator.

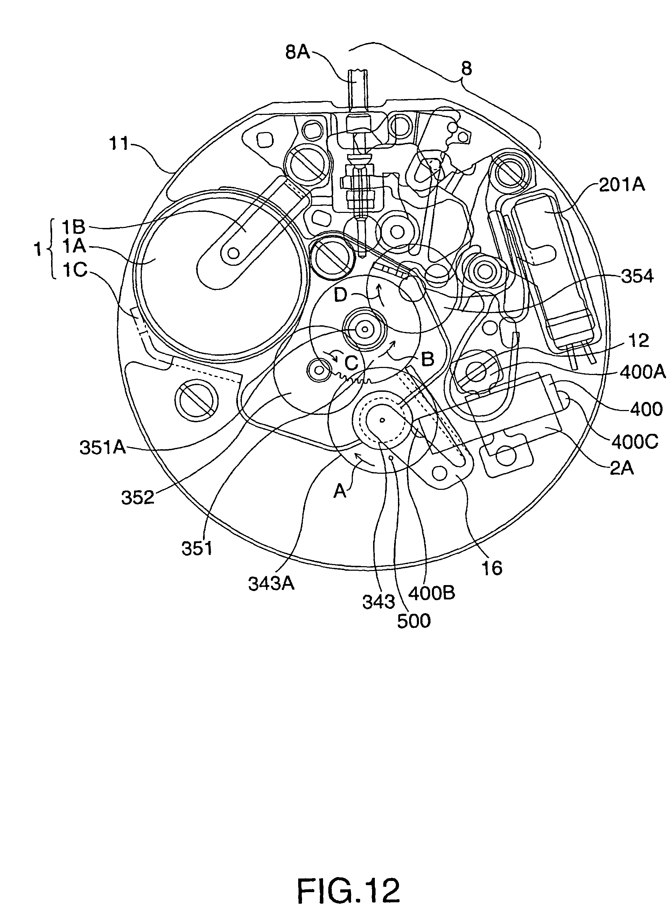

Fig. 12 is a plan view of an analog electronic timepiece according to a sixth embodiment. In Fig. 12, the same parts as those in Fig. 2 are represented by the same reference numerals.

In the analog electronic timepiece according to the sixth embodiment, as shown in Fig. 12, the various mechanisms illustrated in the block diagram shown in Fig. 1 are arranged on the base plate 11 in a well-organized manner.

More particularly, in the analog electronic timepiece according to the sixth embodiment, the battery 1A, the negative terminal 1B, and the positive terminal 1C, the three constituting the power source 1, the time corrector 8 including the crown 8A, the quartz oscillator 201A constituting the oscillation circuit 201, the IC 2A having the electronic circuit 2 formed therein, and the time-indicating mechanism 5 including a piezoelectric actuator 400 serving as a drive source are arranged on the base plate 11 in a well-organized manner. Here, the circuit retainer 101 lies also in contact with the battery 1A.

Fig. 13 is a sectional view of the time-indicating mechanism 5 including the piezoelectric actuator 400. As shown in Fig. 13, the piezoelectric actuator 400 has a substantially rectangular and plate-like shape.

The piezoelectric actuator 400 has fixing portions 400A integrally formed with the middle portion thereof. One of the fixing portions 400A is fixed to the base plate 11 with the fixing pin 12. In this state, the piezoelectric actuator 400 is arranged so as to be substantially parallel to the base plate 11. As a result, since the piezoelectric actuator 400 performs a longitudinal vibration and a secondary flexural vibration, the top portion of an abutment portion 400B disposed at the top thereof comes into contact with the periphery of the rotatably-supported rotor 343 while depicting an elliptical path.

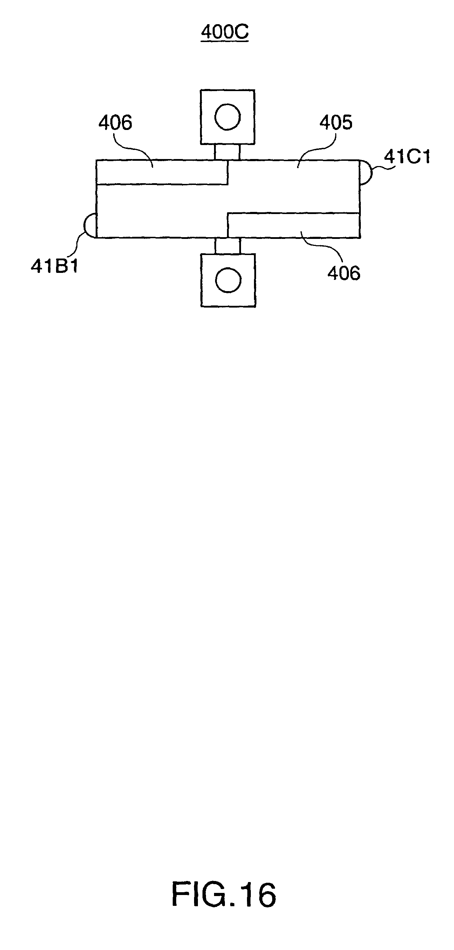

Thus, the piezoelectric actuator is driven by applying drive voltages on central electrodes 401 and electrode pairs 402. In this state, electrode pairs 403 have no drive voltage applied thereon. When the abutment portion 400B of the piezoelectric actuator 400 comes into contact with the periphery of the rotor 343, the rotor 343 rotates in the arrow A direction indicated in Fig. 16 with a frictional force. With this arrangement, the driven wheel 343A integrally formed with the rotor 343 rotates in the same direction. In addition, the fourth wheel 351 engaging with the driven wheel 343A rotates in the arrow B direction indicated in Fig. 12, so that the second hand 351B fixed to the rotating shaft 351A is driven.

The rotating shaft 351A of the fourth wheel 351 has the driven wheel 351C fixed thereto. The driven wheel 351C has the third wheel 352 engaging therewith, and the third wheel 352 thus rotates in the arrow C direction indicated in Fig. 13. The rotating shaft 352A of third wheel 352 has the driven wheel 352B fixed thereto. Furthermore, the driven wheel 352B has the second wheel 353 engaging therewith. Accordingly, the minute hand 353B fixed to the rotating shaft 353A of the second wheel 353 is driven with a rotation of the second wheel 353.

The rotating shaft 353A of the second wheel 353 has the driven wheel 353C fixed thereto. The driven wheel 353C has the minute wheel 354 engaging therewith, and the minute wheel 354 thus rotates in the arrow D direction indicated in Fig. 12.

According to the sixth embodiment, among the component members constituting the analog electronic timepiece, the piezoelectric actuator (vibrator) is disposed so as to overlap two-dimensionally with a part of the component members which do not affect an increase in thickness after the arrangement of the piezoelectric actuator, whereby the two-dimensional shape of the analog electronic timepiece can be made small.

[7] Concrete Structures of Piezoelectric Actuators

Although the concrete structure of the piezoelectric actuator 341 (400) has not been described above, the following structures are specifically possible.

In the first place, the structure according to the following shape is employed in order to improve the drive efficiency of the piezoelectric actuator 341. That is, the dimensions of the piezoelectric actuator 341 are set as shown below:

7 mm × 2 mm × 0.4 mm in thickness. In this case, two piezoelectric elements, each composed of PZT having a thickness of 0.15 mm, and a backing board composed of a stainless steel plate having a thickness of 0.1 mm are used.

By employing an aspect ratio formed by such dimensions of about 7 mm × 2 mm, resonant frequencies of the foregoing longitudinal vibration and secondary flexural vibration agree with each other, whereby an elliptical drive is effectively performed.

In this case, preferably the resonant frequency of the secondary flexural vibration lies in the range of 0.97 times to 1.03 times that of the longitudinal vibration.

For example, the resonant frequencies are shown as follows:

284.3 kHz for the longitudinal vibration, and

288.6 kHz for the secondary flexural vibration (1.015 times the resonant frequency of the longitudinal vibration).

According to the above example setting of the resonant frequencies, the piezoelectric actuator 341 was able to provide a satisfactory elliptical vibration.

In the meantime, the resonant frequencies of the longitudinal vibration and the secondary flexural vibration can be easily controlled by varying the aspect ratio of the piezoelectric actuator 341. In the case of the foregoing example, in a state in which the longitudinal length is fixed at 7 mm, when the lateral length is made smaller than 2 mm, a difference between the resonant frequencies becomes smaller, and, when the lateral length is made greater than 2 mm, the difference between the resonant frequencies becomes greater. This is ascribable to the fact that, when only the lateral length is changed, only the resonant frequency of the secondary flexural vibration varies without causing the resonant frequency of the longitudinal vibration to vary.

To be more specific, although, since they vary due to Young's moduli of the piezoelectric elements and the backing board, optimization taking these Young moduli into account is necessary, it has been known that a preferable aspect ratio is about 7:2. Meanwhile, the resonant frequency of the secondary flexural vibration decreases in accordance with the mass of the abutment portion 341B of the piezoelectric actuator 341.

The way of setting an optimal drive frequency will be now described.

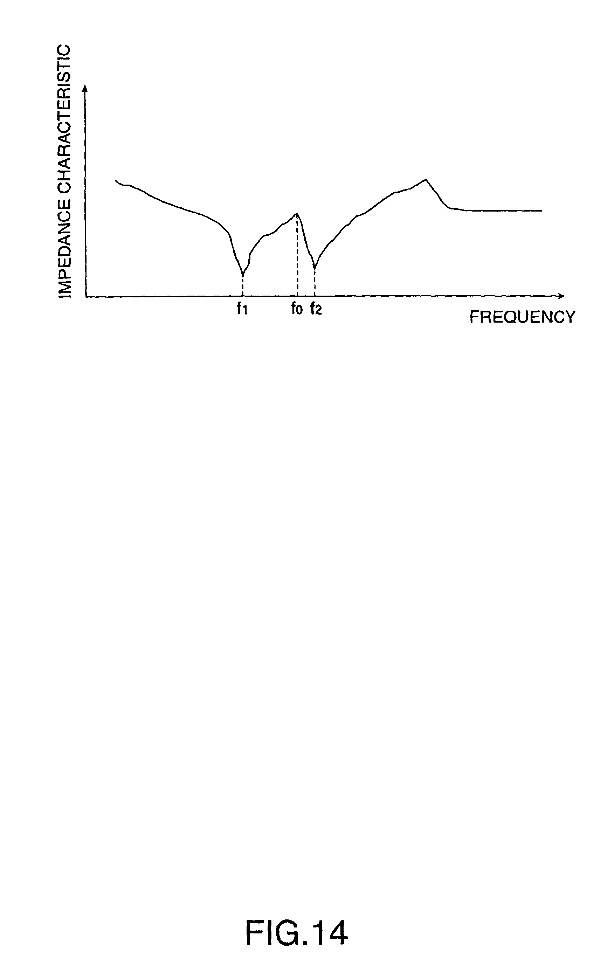

Fig. 14 is a graph illustrating a frequency-impedance characteristic of the piezoelectric actuator having the concrete structure.

As shown in Fig. 14, the frequency-impedance characteristic of the piezoelectric actuator 341 exhibits an antiresonant frequency f0 between a minimal value of the longitudinal vibration (a resonant frequency of the longitudinal vibration) f1 and a minimal value of the secondary flexural vibration (a resonant frequency of the secondary flexural vibration) f2.

In the case of the foregoing example, the resonant frequency f1 of the longitudinal vibration is equal to 284.3 kHz, and the resonant frequency f2 of the secondary flexural vibration is equal to 288.6 kHz. Accordingly, by setting a drive frequency (excitation frequency) of the piezoelectric actuator 341 in the range from 280 to 290 kHz, the longitudinal vibration and the secondary flexural vibration can be excited at the same time.

Preferably, a drive frequency of the piezoelectric actuator 341 may be set so as to lie between the resonant frequency f1 of the longitudinal vibration and the resonant frequency f2 of the secondary flexural vibration. In the case of the foregoing example, the drive frequency of the piezoelectric actuator is given by the following formula:

$$f1 = 284.3 \text{ kHz} \leq \text{drive frequency} \leq f2 = 288.6 \text{ kHz}.$$

More preferably, the drive frequency of the piezoelectric actuator is set higher than the antiresonant frequency f0 lying between the resonant frequency f1 of the longitudinal vibration and the resonant frequency f2 of the secondary flexural vibration and lower than the resonant frequency f2 of the secondary flexural vibration.

That is, the drive frequency is given by the following formula:

$$f0 < \text{drive frequency} \leq f2.$$

Consequently, a larger elliptical vibration (a combined vibration of the longitudinal vibration and the secondary flexural vibration) can be provided, thereby achieving a more effective drive. Also, harsh knocking sounds are less generated than when an electromagnetic stepping motor is used.

[8] Modifications

Although the present invention has been described in accordance with each of the embodiments, the present invention is not limited to them. A variety of modifications will be described below.

[8.1] First Modification

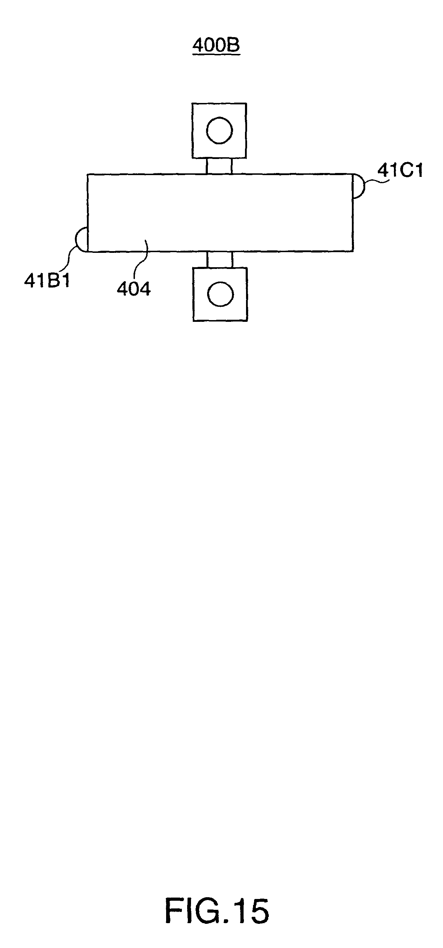

Fig. 15 is an illustration of an example electrode arrangement of a piezoelectric actuator.

As shown in Fig. 15, a piezoelectric actuator 400B according the present modification has an entire-surface electrode 404 disposed on each surface thereof.

Also, by disposing an abutment portion 341B1 and a balancing portion 341C1 at unbalanced positions of the piezoelectric actuator 341 in place of the abutment portion 341B of the same, the piezoelectric actuator 341 is made in a mechanically unbalanced state so as to generate a longitudinal vibration and a secondary flexural vibration.

Although two of the abutment portion 341B1 and the balancing portion 341C1 are disposed as abutment portions in the present modification, it does not matter to dispose a single of the abutment portion 341B1.

[8.2] Second Modification

Fig. 16 is an illustration of an electrode arrangement of another piezoelectric actuator.

The piezoelectric actuator according to the first modification illustrated in Fig. 15 has a structure in which the entire-surface electrode 404 is disposed on each surface thereof. Instead of this structure, as shown in Fig. 16, a piezoelectric actuator 400C according to the present modification has a structure in which a drive electrode 405 extending between the abutment portion 341B1 and the balancing portion 341C1 and a detecting-electrode pair 406 are disposed on each surface thereof.

By employing such a structure, when a drive voltage is applied on the drive electrodes 405, a longitudinal vibration of each piezoelectric element is excited, and also imbalance between expansion and contraction of the piezoelectric element occurs. In addition, due to a mechanical unbalanced state caused by the abutment portion 341B1 and the balancing portion 341C1, a secondary flexural vibration is more reliably excited.

Thus, the longitudinal vibration and the secondary flexural vibration are combined so as to generate an elliptical vibration.

Also, by using the detecting-electrode pairs 406 as detecting electrodes for detecting the vibrating state because of the same reason as in the first modification, a more accurate control is possible.

[8.3] Third Modification

In the above descriptions, although the rotor is driven in one direction, it is possible to drive it in both normal and reverse directions.

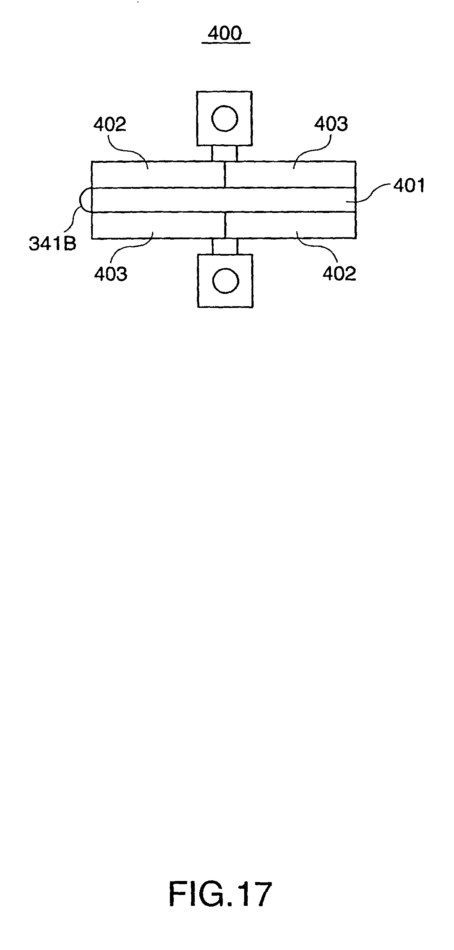

Fig. 17 is an illustration of an electrode arrangement of a piezoelectric actuator for a drive in both normal and reverse directions.

As shown in Fig. 17, with the electrode arrangement of a piezoelectric actuator 400 according to the third modification, the central electrode 401 and two sets of the electrode pairs 402 and 403, each set arranged so as to intersect with each other with respect to the central electrode 401, are disposed on each surface thereof.

With this structure, in order to generate an elliptical drive in a first direction (the normal direction), the central electrodes 401 and the electrode pairs 402 have drive voltages applied thereon. In this state, the electrode pairs 403 have no drive voltage applied thereon.

As a result, although a longitudinal vibration is excited by the central electrodes 401, since the drive voltage is applied only on the electrode pairs 402 between the electrode pairs 402 and 403, imbalance between expansion and contraction of each piezoelectric element due to the longitudinal vibration occurs, thereby exciting a secondary flexural vibration corresponding to the first direction.

Thus, the longitudinal vibration and the secondary flexural vibration are combined so as to generate an elliptical vibration in the first direction.

Meanwhile, in order to generate an elliptical drive in a second direction (the reverse direction), the central electrodes 401 and the electrode pairs 403 have drive voltages applied thereon. In this state, the electrode pairs 402 have no drive voltage applied thereon.

As a result, although a longitudinal vibration is excited by the central electrodes 401, since the drive voltage is applied only on the electrode pairs 403 between the electrode pairs 402 and 403, imbalance between expansion and contraction of each piezoelectric element due to the longitudinal vibration occurs, thereby exciting a secondary flexural vibration corresponding to the second direction.

Thus, the longitudinal vibration and the secondary flexural vibration are combined so as to generate an elliptical vibration in the second direction.

In this case, it is preferable that one of the electrode pairs having no drive voltage applied thereon be used as detecting electrodes for detecting the vibrating state. The reason for this is such that, since a piezoelectric element generates heat due to its vibrations, and a Young's Modulus and other characteristics thereof vary due to a change in temperature, instead of controlling a drive frequency in a fixed manner, it is preferable that a voltage generated due to the vibrations be detected with the electrode pair having no drive voltage applied thereon and the drive frequency be controlled so as to make a phase difference or an absolute value of the voltage agree with a predetermined control target value.

[8.4] Fourth Modification

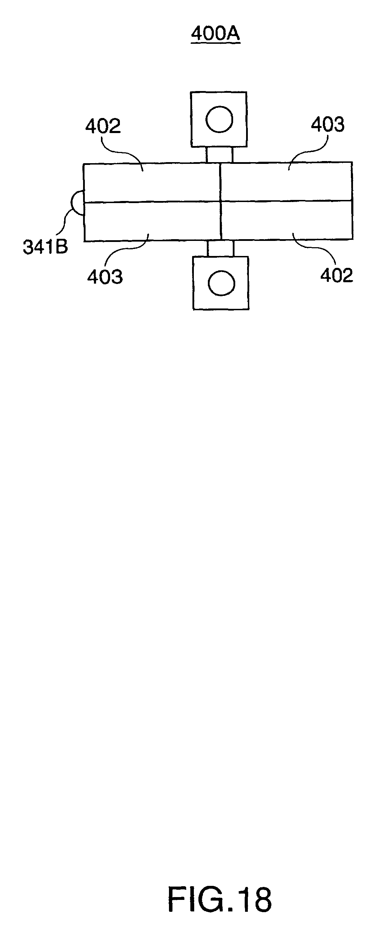

Fig. 18 is an illustration of an electrode arrangement of another piezoelectric actuator for a drive in both normal and reverse directions.

Although the central electrodes 401 and the two pairs of electrode pairs 402 and 403 are disposed on each surface of the actuator in the above-described modification, as shown in Fig. 18, in a piezoelectric actuator 400A according to the present modification, the central electrodes 401 are eliminated, and only two sets of the electrode pairs 402 and 403 are disposed on each surface thereof.

With this arrangement, in order to generate an elliptical drive in the first direction (the normal direction), the electrode pairs 402 have a drive voltage applied thereon. In this state, the electrode pairs 403 have no drive voltage applied thereon.

As a result, when the drive voltage is applied on the electrode pairs 402, a longitudinal vibration of each piezoelectric element is excited, and also imbalance between expansion and contraction of the piezoelectric element occurs, thereby exciting a secondary flexural vibration corresponding to the first direction.

Thus, the longitudinal vibration and the secondary flexural vibration are combined so as to generate an elliptical vibration in the first direction.

Meanwhile, in order to generate an elliptical drive in the second direction (the reverse direction), the electrode pairs 403 have a drive voltage applied thereon. In this state, the electrode pairs 402 have no drive voltage applied thereon.

As a result, when the drive voltage is applied on the electrode pairs 403, a longitudinal vibration of each piezoelectric element is excited, and also imbalance between expansion and contraction of the piezoelectric element occurs, thereby exciting a secondary flexural vibration corresponding to the second direction opposite to the first direction.

Thus, the longitudinal vibration and the secondary flexural vibration are combined so as to generate an elliptical vibration in the second direction.

Also, in these cases, it is preferable that one of the electrode pairs having no drive voltage applied thereon be used as detecting electrodes for detecting the vibrating state because of the same reason as in the foregoing modifications.

[8.5] Fifth Modification

Although a location at which each of the piezoelectric actuators is supported has not been described in detail, by supporting the central portion thereof which serves as a node of both longitudinal vibration and secondary flexural vibration, a vibration loss can be reduced.

[8.5] Fifth Modification

So far, two arrangements have been described: one in which the piezoelectric actuator 341 is disposed so as not to overlap two-dimensionally with the fourth wheel 351, the third wheel 352, the second wheel 353, the minute wheel 354, the scoop wheel 355, and the like, and the other in which the piezoelectric actuator 341 is disposed so as to overlap two-dimensionally with a mechanism including the transfer mechanism 4 and the time-indicating mechanism 5. However, among component members constituting the analog electronic timepiece, the vibrator may be disposed so as to overlap two-dimensionally with a part of the component members which do not affect an increase in thickness after its arrangement.

In this case, the part of the component members which does affect an increase in thickness after the arrangement include, for example, the battery and a quartz crystal which are decisive in determining the overall thickness of the timepiece movement. Accordingly, the part of the component members which do not affect an increase in thickness after the arrangement include a circuit board, an IC circuit, the train wheel, the base plate, a variety of receiving members, a time correcting member, the circuit retainer, and a calendar mechanism. Also, since a gear, a pressure spring, a pressing plate, the base plate, and the like disposed above and blow the rotor wheel are cross-sectionally different from the vibrator, by arranging them so as to overlap two-dimensionally with the vibrator, a greater effect can be obtained.

[8.6] Sixth Modification

Also, the position detector 100 is not limited to the foregoing structure having the jumper spring 19 used therein; instead, for example, a non-contact sensor (a photo sensor, a magnetic sensor, a capacitive sensor, or the like) may be used. Although a position of the fourth wheel 351 is detected, the detecting position is not limited to this, and a position of any one of the rotor, the transfer wheels, the indicating components (indicating hands), and the like may be detected. When a photo sensor is used, a detecting method may be of a transmissive type, a reflective type, or the like. In order to achieve a thin structure of the timepiece, a reflective type is preferable.

[8.7] Seventh Modification

Also, the piezoelectric actuator 341 may drive a fifth wheel arranged so as to be concentric with the rotor 343 and to rotate integrally therewith, and also the rotor 343 itself may be used as a fourth wheel. In the case of a timepiece having two hands (hour and minute hands), the rotor 343 may drive a third wheel and also the rotor 343 itself may be used as a second wheel. Hour, minute, and second hands may be independently driven by respective drive sources.

[8.8] Eighth Modification

An indicating method of the time-indicating mechanism is not limited to rotations (hands), any one of slides, a sector shape, a drum shape, and the like may be used. Although an example pressing angle of each of the piezoelectric actuators in the figures is set at about 30 degrees, the angle is not limited to this value, and it is apparent that another pressing angle can be set.

[8.9] Ninth Modification

Also, a balancing portion 341C may be disposed at an end of the piezoelectric actuator 341, on the opposite side of the abutment portion 341B of the same, so as to induce a larger flexural vibration and thus to generate a larger torque.

[9] Advantages of the Embodiments

As described above, according to the embodiments, it is sufficient to provide only a single vibrator and a single drive circuit, thereby achieving a simplified structure and also a reduced cost. In addition, since the single vibrator is disposed, a drive (vibration) is performed more stably than when a plurality of vibrators is disposed.

Furthermore, since detecting electrodes are disposed, the vibrating state can be detected, thereby driving a piezoelectric actuator at an optimal frequency.

Still furthermore, a highly effective drive can be performed by reducing a vibration loss.

[Advantages of the Invention]

According to the present invention, a driven body is driven with a vibration of a plate-like vibrator, and a time-indicating mechanism operates with a drive of the driven body directly or via a transfer mechanism, thereby achieving higher transfer efficiency and a smaller and thinner structure without making a timepiece movement thicker than those with the related art.

**Claims**

1. An analog electronic timepiece, comprising: a plate-like vibrator; a driven body driven with a vibration of the vibrator; and a time-indicating mechanism operating with a drive of the driven body directly or via a transfer mechanism.

2. The analog electronic timepiece according to Claim 1, wherein the plate-like vibrator is a piezoelectric actuator which comprises a diaphragm formed by stacking at least one plate-like piezoelectric element and a plate-like reinforcing member; at least one fixing portion for fixing the diaphragm to a supporting body; and an abutment portion disposed at a longitudinal end of the diaphragm, and in which, by feeding a drive signal to the piezoelectric element, the piezoelectric element expands and contracts so as to generate vibrations causing the diaphragm to expand and contract in the longitudinal direction thereof as well as in a direction at an angle with the longitudinal direction so that the driven body is driven with a displacement of the abutment caused by these vibrations, and wherein the abutment portion and the driven body are pressed by pressing means.

3. The analog electronic timepiece according to Claim 1 or 2, wherein the vibrator is disposed so as not to overlap two-dimensionally with the driven body or the transfer mechanism.

4. The analog electronic timepiece according to Claim 1 or 2, wherein the vibrator is disposed so as to overlap two-dimensionally with a mechanism including the transfer mechanism and the time-indicating mechanism.

5. The analog electronic timepiece according to Claim 1 or 2, wherein, among component members constituting the analog electronic timepiece, the vibrator is disposed so as to overlap two-dimensionally with a part of the component members which do not affect an increase in thickness after its arrangement.

6. The analog electronic timepiece according to Claim 1 or 2, wherein the driven body comprises pressing means for pressing the vibrator.

7. The analog electronic timepiece according to Claim 1 or 2, wherein the vibrator comprises pressing means for pressing the driven body.

8. The analog electronic timepiece according to Claim 7, wherein a pressing force of the pressing means is exerted substantially in a circumferential direction of a driven wheel which is the driven body and is the first to be driven among the transfer mechanism.

9. The analog electronic timepiece according to Claim 7, wherein a pressing force of the pressing means is exerted substantially in the center-oriented direction of a driven wheel which is the driven body and is the first to be driven among the transfer mechanism.

```
                              ┌─────────────────┐
                              │  POWER SOURCE   │～ 1
                              └─────────────────┘
                                      │                                    ～2
                                      ▼
 ┌ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ─ ┐
        ～2361                                              ～201
   ┌──────────────┐                                   ┌──────────────┐
 │ │  OSCILLATION │ ◄──────────────────────┐          │  OSCILLATION │    │
   │   CIRCUIT    │                         │          │   CIRCUIT    │
 │ └──────────────┘          225           │          └──────────────┘    │
          │                  ～                           │  32768Hz    ～202
 │        ▼     ～2362   ┌──────────────────┐             ▼                │
   ┌──────────────┐     │                  │◄─┐      ┌──────────────┐
 │ │   WAVEFORM-  │     │ CONTROL CIRCUIT  │  │ 1Hz  │  FREQUENCY   │      │
   │   SHAPING    │     │                  │◄─┴──────│   DIVIDER    │
 │ │   CIRCUIT    │     └──────────────────┘         └──────────────┘      │
   └──────────────┘       ▲        ▲
 │        │     ～2363     │        │                                      │
          ▼               │        │
 │ ┌──────────────┐       │        │                                      │
   │  MOTOR-DRIVE │       │        │
 │ │   CIRCUIT    │       │        │                                      │
   └──────────────┘       │        │
 └ ─ ─ ─ ─│─ ─ ─ ─ ─ ─ ─ ─│─ ─ ─ ─ │─ ─ ─ ─ ─ ─ ─ ─ ─ ─ ─ ─ ─ ─ ─ ─ ─ ─ ┘
          ▼                │        │
   ┌──────────────┐  ～341 │        │
   │ PIEZOELECTRIC│────────┘        │
   │   ACTUATOR   │                 │
   └──────────────┘                 │                       100
          │      ～343              │                       ～
          ▼                         │          ┌────────────────────────┐
   ┌──────────────┐                 └──────────│   POSITION DETECTOR     │
   │    ROTOR     │                   ┌────────│                         │
   └──────────────┘                   │        └────────────────────────┘
          │      ～4                  │                   5
          ▼                           │                   ～
 ┌──────────────────┐                 │      ┌────────────────────────────┐
 │TRANSFER MECHANISM│─────────────────┘      │  TIME-INDICATING MECHANISM  │
 │ (SPEED-REDUCTION │────────────────────────│ (SECOND, MINUTE, HOUR HANDS)│
 │  TRAIN WHEEL)    │                        └────────────────────────────┘
 └──────────────────┘                                     ▲
                                                          │   ～8
                                              ┌────────────────────────────┐
                                              │   TIME CORRECTOR (CROWN)    │
                                              └────────────────────────────┘
```

# FIG. 1

**FIG. 2**

FIG. 3

14

FIG. 4

**FIG. 5**

LONGITUDINAL VIBRATION

**FIG. 6**

**FIG. 7**

FIG. 8

FIG. 9

EP 1 439 435 A1

# FIG.10

FIG.11

# FIG.12

FIG.13

FIG.14

400B

41C1

41B1    404

FIG.15

<u>400C</u>

406        405

41C1

41B1        406

# FIG.16

<u>400</u>

402   403

401

341B

403   402

FIG.17

400A

402    403

341B    403    402

FIG.18

## INTERNATIONAL SEARCH REPORT

| | International application No. |
| --- | --- |
| | PCT/JP03/10914 |

A. CLASSIFICATION OF SUBJECT MATTER
Int.Cl⁷ G04C3/12, H02N2/00

According to International Patent Classification (IPC) or to both national classification and IPC

B. FIELDS SEARCHED

Minimum documentation searched (classification system followed by classification symbols)
Int.Cl⁷ G04C3/12, H02N2/00

Documentation searched other than minimum documentation to the extent that such documents are included in the fields searched

| | | | |
| --- | --- | --- | --- |
| Jitsuyo Shinan Koho | 1922-1996 | Toroku Jitsuyo Shinan Koho | 1994-2003 |
| Kokai Jitsuyo Shinan Koho | 1971-2003 | Jitsuyo Shinan Toroku Koho | 1996-2003 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2000-188882 A (Seiko Epson Corp.), 04 July, 2000 (04.07.00), Description, Par. No. [0108] & WO 00/38309 A1 & JP 2000-245179 A & JP 2000-188888 A1 & JP 2000-333480 A & CN 1291373 T & EP 1075079 A1 | 1-5,7-9 |
| A | JP 53-045572 A (Daini Seikosha Kabushiki Kaisha), 24 April, 1978 (24.04.78), Full text; all drawings (Family: none) | 1-9 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 07 October 2003 (07.10.03) | 21 October, 2003 (21.10.03) |

| Name and mailing address of the ISA/ | Authorized officer |
| --- | --- |
| Japanese Patent Office | |
| Facsimile No. | Telephone No. |

Form PCT/ISA/210 (second sheet) (July 1998)

## INTERNATIONAL SEARCH REPORT

International application No.

PCT/JP03/10914

| C (Continuation). DOCUMENTS CONSIDERED TO BE RELEVANT | | |
|---|---|---|
| Category* | Citation of document, with indication, where appropriate, of the relevant passages | Relevant to claim No. |
| A | Microfilm of the specification and drawings annexed to the request of Japanese Utility Model Application No. 075884/1984(Laid-open No. 188396/1985) (Casio Computer Co., Ltd.), 13 December, 1985 (13.12.85), Full text; all drawings (Family: none) | 1-9 |
| A | JP 62-223689 A (Citizen Watch Co., Ltd.), 01 October, 1987 (01.10.87), Full text; all drawings (Family: none) | 1-9 |
| A | JP 11-127585 A (Seiko Instruments Inc.), 11 May, 1999 (11.05.99), Full text; all drawings & US 2002-36445 A1 | 1-9 |
| A | Microfilm of the specification and drawings annexed to the request of Japanese Utility Model Application No. 076978/1986(Laid-open No. 191395/1987) (Casio Computer Co., Ltd.), 05 December, 1987 (05.12.87), Full text; all drawings (Family: none) | 1-9 |

Form PCT/ISA/210 (continuation of second sheet) (July 1998)

**EP 1 439 435 A1**

## INTERNATIONAL SEARCH REPORT

| International application No. |
| --- |
| PCT/JP03/10914 |

**Box I   Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box II   Observations where unity of invention is lacking (Continuation of item 3 of first sheet)**

This International Searching Authority found multiple inventions in this international application, as follows:

   (See extra sheet)

1. ☐ As all required additional search fees were timely paid by the applicant, this international search report covers all searchable claims.

2. ☒ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐ The additional search fees were accompanied by the applicant's protest.

☐ No protest accompanied the payment of additional search fees.

Form PCT/ISA/210 (continuation of first sheet (1)) (July 1998)

30

| **INTERNATIONAL SEARCH REPORT** | International application No. |
|---|---|
| | PCT/JP03/10914 |

<u>Continuation of Box No. II of continuation of first sheet(1)</u>

Our investigation evidenced that the subject matter pertaining to Claims 1 and 2 are still at the level of a prior art disclosed in Document JP 2000-188882 A (Seiko Epson Corp.).

Claims 3-5 relate to a technology on the arrangement of an oscillating body in an analog electronic timepiece as described in Claims 1 and 2.

Claims 6-9 relate to a technology on a pressing force between the oscillating body and a driven body in the analog electronic timepiece as described in Claims 1 and 2.

The subject matters as described in Claims 1 and 2 commonly pertaining to Claims 3-9 are still at the level of the prior art as mentioned above, they do not provide any special technical feature as described in the meaning of the second sentence of PCT rule 13.2.

Since there is no other common matter considered to be a special technical feature in the meaning of the second sentence of PCT rule 13.2 in the matters described in the Claims except for the matters as described in Claims 1 and 2, any technical relation in the meaning of PCT rule 13 cannot be found between these different inventions.

As a result, it is clear that Claims 3-9 do not fulfill the requirement of unity of invention.

Form PCT/ISA/210 (extra sheet) (July 1998)